# EUROPEAN PATENT APPLICATION

(11) **EP 4 603 852 A1**
(43) Date of publication of application: **20.08.2025**
(21) Application number: 24217460.5
(22) Date of filing: 04.12.2024
(51) Int. Cl.: G01R 31/382, H01M 10/48, G01R 33/00, G01R 33/02

(54) **MEASUREMENT DEVICE AND ESTIMATION SYSTEM**

(30) Priority: 15.02.2024 JP 2024020940
(71) Applicant: Yokogawa Electric Corporation, Tokyo 180-8750 (JP)
(72) Inventor: TSUKANO, Masahito, Musashino-shi, Tokyo, 180-8750 (JP); TAKENAKA, Kazuma, Musashino-shi, Tokyo, 180-8750 (JP); TERAO, Minako, Musashino-shi, Tokyo, 180-8750 (JP); NOGUCHI, Naoki, Musashino-shi, Tokyo, 180-8750 (JP); INAMURA, Kazuhiko, Musashino-shi, Tokyo, 180-8750 (JP)
(74) Representative: Hoffmann Eitle

(57) **Abstract**

Provided is a measurement device which measures a magnetic flux density emitted from a battery cell, comprising: a sensor including sensor cells which measure the magnetic flux density; and a rotation holding unit which rotatably holds the battery cell in a state where a relative position of the battery cell with respect to the sensor cells is retained. The rotation holding unit may hold the battery cell such that the relative position between the battery cell and the sensor is changeable. The rotation holding unit may include a rotating portion which rotates the battery cell. The rotation holding unit may move the sensor cells with respect to the battery cell. (Selected drawing) Fig. 1

## Description

### BACKGROUND

### 1. TECHNICAL FIELD

The present invention relates to a measurement device and an estimation system.

### 2. RELATED ART

A battery unit including a lithium-ion battery or the like is constituted by a plurality of battery cells and used as a power supply for an electrical car or the like.

Conventionally, there have been techniques for measuring magnetic flux density at a plurality of points around a battery (Patent Document 1).

### Prior Art Document

### Patent Document

Patent Document 1: Japanese Unexamined Patent Publication No. 2018-46007

### SUMMARY

In a first aspect of the present invention, provided is a measurement device which measures a magnetic flux density emitted from a battery cell, comprising: a sensor including sensor cells which measure the magnetic flux density; and a rotation holding unit which rotatably holds the battery cell in a state where a relative position of the battery cell with respect to the sensor cells is retained. The sensor may include a plurality of sensor cells arranged in a two-dimensional array and each sensor cell may output a measurement result of magnetic flux densities in the X-axis direction, the Y-axis direction, and the Z-axis direction.

In the measurement device described above, the rotation holding unit may hold the battery cell such that the relative position between the battery cell and the sensor is changeable.

In any of the measurement devices described above, the rotation holding unit may include a rotating portion which rotates the battery cell. The rotating portion may cause the battery cell to be rotated about its rotational axis in the Y-axis direction in a state where the battery cell is held between the first energizing terminal and the second energizing terminal.

In the measurement device described above, the rotation holding unit may move the sensor cells with respect to the battery cell.

Any of the measurement devices described above may further comprise a control unit which takes in measurement results of the magnetic flux density at the sensor at at least two rotation angles of the battery cell.

In the measurement device described above, the control unit may control the relative position between the sensor and the battery cell and, in each of at least two relative positions, each relative position being identical to the relative position, take in the measurement results at the at least two rotation angles.

In any of the measurement devices described above, the rotation holding unit may further include: a cell substrate to which the rotating portion is fixed; and a sensor substrate to which the sensor is fixed, wherein the cell substrate may be movable relative to the sensor substrate.

In the measurement device described above, the sensor substrate may include a plurality of positioning holes for determining the relative position between the sensor and the battery cell, and the cell substrate may include a positioning pin to be inserted into the plurality of positioning holes. The plurality of positioning holes may be for positioning the cell substrate in a plurality of different positions.

The sensor substrate may include a rail for moving the relative position between the sensor and the battery cell.

In any of the measurement devices described above, the rotation holding unit may include a moving portion which moves the relative position between the sensor and the battery cell.

In any of the measurement devices described above, the rotation holding unit may include: a cell holding portion which has the battery cell inserted thereinto and includes a recessed portion or a protruding portion for defining a rotation angle; and a support portion which is fixed to the cell substrate and contacts with and supports the recessed portion or the protruding portion of the cell holding portion.

In the measurement device described above, the support portion may be rotatable about a rotational axis that is the same as a rotational axis of the battery cell.

In any of the measurement devices described above, the control unit may take in a plurality of measurement results of the magnetic flux density at the sensor at each of the at least two rotation angles and record an average value of the plurality of measurement results at each rotation angle in a database.

In any of the measurement devices described above, the control unit may take in a measurement result of the magnetic flux density at the sensor when passing a current having a current value higher than a registered current value through the battery cell and record in a database the measurement result of the magnetic flux density in association with the registered current value. The control unit may take in a measurement result of the magnetic flux density at the sensor when passing a current having a current value calculated by multiplying the registered current value by a predetermined energizing coefficient through the battery cell and record in a database the measurement result of the magnetic flux density in association with the registered current value.

In a second aspect of the present invention, provided is an estimation system comprising a database which, for at least one type of a battery cell used for a battery unit, records a measurement result obtained by actually measuring a magnetic flux density for each angle state when passing a current while changing the angle state of the battery cell; a state input unit to which, for the battery unit including a plurality of battery cells, each battery cell being identical to the battery cell, state data indicating an arrangement and an angle state of each of the battery cells within the battery unit is input; and an estimation unit which, based on the angle state and the measurement result recorded in the database, determines a magnetic flux density generated by each of the battery cells, and, based on the magnetic flux density generated by each of the battery cells and the arrangement of each of the battery cells, estimates a magnetic flux density generated by the battery unit.

The estimation system described above may further comprise an acquisition unit which acquires the measurement result actually measured using a measurement device to record it in the database, wherein the measurement device measures a magnetic flux density emitted from a battery cell and comprises: a sensor including sensor cells which measure the magnetic flux density; and a rotation holding unit which rotatably holds the battery cell in a state where a relative position of the battery cell with respect to the sensor cells is retained.

Note that the summary clause does not necessarily describe all necessary features of the embodiments of the present invention. In addition, the invention may also be a sub-combination of the features described above.

### BRIEF DESCRIPTION OF THE DRAWINGS

Fig. 1 illustrates a schematic view of a measurement device 10 according to the present embodiment.
Fig. 2 is a perspective view illustrating the rotation holding unit 30 in the measurement device 10 according to the present embodiment in more detail.
Fig. 3 is a schematic top plan view illustrating a holding jig 60 and a cell substrate 235, which are parts of the rotation holding unit 30.
Fig. 4 is a schematic perspective view of the holding jig 60, which is a part of the rotation holding unit 30 when viewed from above.
Fig. 5 is a schematic perspective view of the holding jig 60, which is a part of the rotation holding unit 30 when viewed from below.
Fig. 6 illustrates an arrangement of the sensor cells 22 and the battery cell 15 during the measurement.
Fig. 7 illustrates a schematic perspective view of the holdingjig 60 in the rotation holding unit 30 of a first variant in the measurement device 10 of the present embodiment.
Fig. 8 illustrates a top plan view of the holding jig 60 of a first variant.
Fig. 9 illustrates a schematic top plan view of a part of the rotation holding unit 30 of a second variant in the measurement device 10 of the present embodiment.
Fig. 10 is a flow diagram illustrating a measurement operation of the measurement device 10 of the present embodiment.
Fig. 11 illustrates an example of the measurement result database which records measurement results in the measurement device 10.
Fig. 12 illustrates a schematic view of an estimation system 800 according to the present embodiment.
Fig. 13 illustrates a flow diagram of a genuine product determination operation in the estimation system 800 according to the present embodiment.

### DESCRIPTION OF EXEMPLARY EMBODIMENTS

The present invention will be described below through embodiments of the invention, but the following embodiments do not limit the invention according to the claims. In addition, not all of the combinations of features described in the embodiments are essential to the solution of the invention.

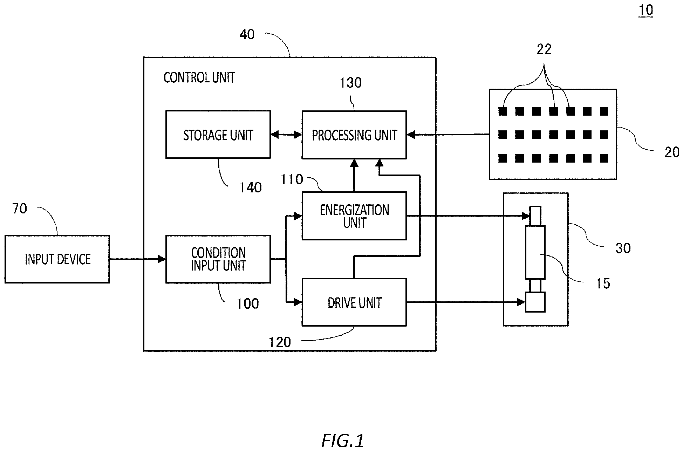

Fig. 1 illustrates a schematic view of a measurement device 10 according to the present embodiment. Fig. 1 illustrates the schematic view of the measurement device 10 on which a battery cell 15 to be measured is arranged.

Here, a magnetic field generated in a battery unit such as a lithium-ion battery during energizing (charging or discharging) varies due to a type and an arrangement of the battery cell 15 included therein. Thus, by energizing a battery unit that is already shipped to measure its magnetic flux density, it becomes possible to distinguish it from other individuals and determine that it is a genuine product. However, the magnetic flux density varies depending on an angle state of the battery cell 15 due to an arrangement of a battery tab (lead wire) inside the battery cell 15 or the like. Therefore, when a genuine product determination is performed on a battery unit from its magnetic flux density, measurement data of the magnetic flux density that differs depending on an angle state of a battery cell in a genuine battery unit is required in advance. In particular, in a case where a genuine product determination by means of machine learning is employed, a large amount of measurement data is required for training a determiner. The measurement device 10 of the present embodiment can acquire such measurement data for the genuine product determination on the battery unit by actually measuring it, as an example.

The measurement device 10 of the present embodiment measures the magnetic flux density emitted from the battery cell 15 at a plurality of rotation angles. The measurement device 10 includes a sensor 20, a rotation holding unit 30, and a control unit 40. For the measurement device 10 of the present embodiment, the arrangement, the dimension, the number thereof, and the like in each configuration may be set depending on the battery cell 15 in the battery unit to be determined if it is a genuine product; and the arrangement of the battery cell 15 and the sensor 20 upon the genuine product determination, as an example.

The sensor 20 may output a measurement result depending on a magnetic field of at least one of an X-axis direction, a Y-axis direction, or a Z-axis direction. The sensor 20 includes a plurality of sensor cells 22 and is also referred to as a sensor array. The sensor cells 22 each are a Hall element, as an example. The sensor 20 may include the plurality of sensor cells 22 arranged in a two-dimensional array and each sensor cell 22 may output a measurement result of magnetic flux densities in the X-axis direction, the Y-axis direction, and the Z-axis direction.

The rotation holding unit 30 rotatably holds the battery cell 15 in a state where a relative position of the battery cell 15 with respect to the sensor cells 22 is retained. The rotation holding unit 30 may energize the battery cell 15 during the measurement.

The control unit 40 may be a computer such as a PC (Personal Computer), a tablet computer, a smartphone, a workstation, a server computer, or a general-purpose computer or may be a computer system in which a plurality of computers are connected. Such a computer system is also a computer in a broad sense. The control unit 40 may also be implemented by one or more executable virtual computer environments within a computer. The control unit 40 may also be an internal computer of the sensor 20.

The control unit 40 is connected to the sensor 20 and the rotation holding unit 30. The control unit 40 may control various operations in the rotation holding unit 30. The control unit 40 may take in measurement results of a magnetic flux density at the sensor 20 at at least two rotation angles of the battery cell 15. The control unit 40 includes a condition input unit 100, an energization unit 110, a drive unit 120, a processing unit 130, and a storage unit 140.

The condition input unit 100 is connected to an input device 70. A measurement condition on a magnetic flux density may be input from a user via the input device 70 to the condition input unit 100. The input device 70 may be a terminal used by the user (a PC, a smartphone, or the like), a keyboard, a touch panel, a mouse, or the like.

The energization unit 110 is connected to the condition input unit 100. In response to the measurement condition being input to the condition input unit 100, the energization unit 110 may energize the battery cell 15. The energization unit 110 may energize the battery cell 15 by controlling a power supply connected to the battery cell 15. The energization unit 110 may pass through the battery cell 15 a current having a current value indicated in the measurement condition or a predetermined current value.

The drive unit 120 is connected to the condition input unit 100. In response to the measurement condition being input to the condition input unit 100, the drive unit 120 may control the driving of the rotation holding unit 30. The drive unit 120 may control the driving of the rotation holding unit 30 so as to rotate the battery cell 15 at a rotation angle depending on the measurement condition. The drive unit 120 may control the driving of the rotation holding unit 30 so as to move a relative position between the battery cell 15 and the sensor 20 depending on the measurement condition.

The processing unit 130 is connected to the energization unit 110, the drive unit 120, and the sensor 20. The processing unit 130 takes in the measurement result of the magnetic flux density measured by the sensor 20. The processing unit 130 may receive from the energization unit 110 a current value of the current flowing through the battery cell 15. The processing unit 130 may receive from the drive unit 120 data that indicates a state of the rotation holding unit 30 such as the rotation angle of the battery cell 15. The processing unit 130 may perform pre-processing on the taken measurement result and output the pre-processed measurement result to the storage unit 140.

The storage unit 140 is connected to the processing unit 130. The storage unit 140 stores a measurement result database, which records measurement results obtained by actually measuring the magnetic flux density. The storage unit 140 may record in the measurement result database the measurement results in association with measurement conditions.

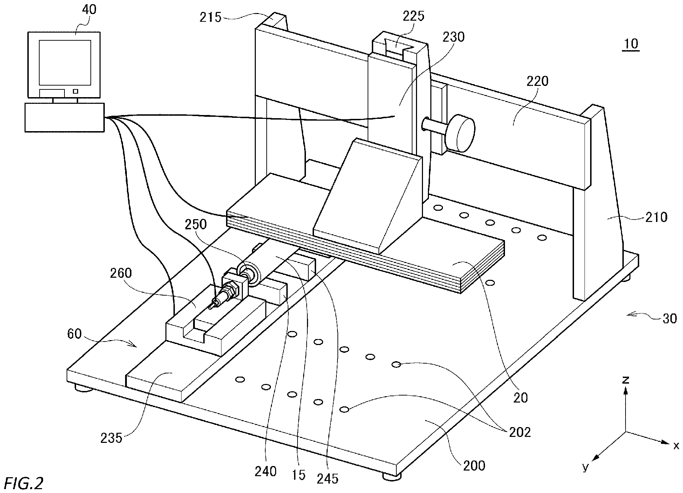

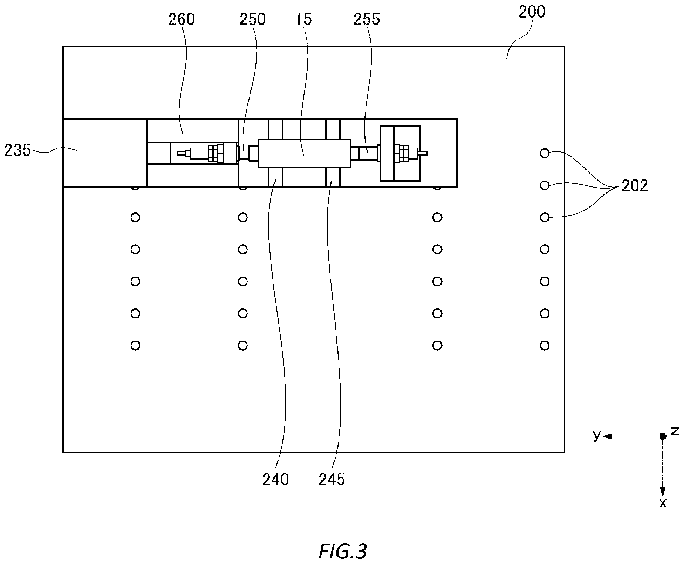

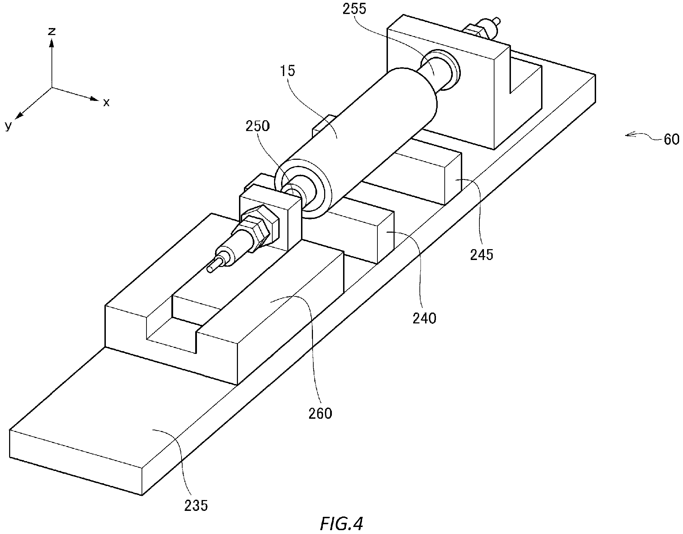

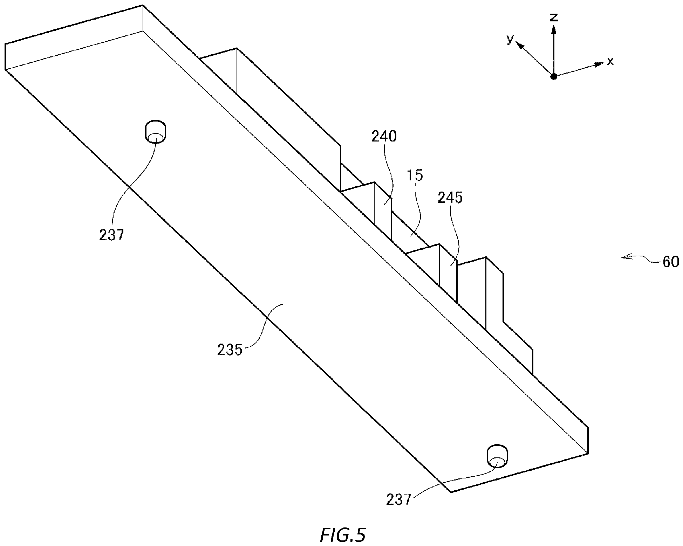

Fig. 2 is a perspective view illustrating the rotation holding unit 30 in the measurement device 10 according to the present embodiment in more detail. Fig. 3 is a schematic top plan view illustrating a holding jig 60 and a cell substrate 235, which are parts of the rotation holding unit 30. Fig. 4 is a schematic perspective view of the holding jig 60, which is a part of the rotation holding unit 30 when viewed from above. Fig. 5 is a schematic perspective view of the holding jig 60, which is a part of the rotation holding unit 30 when viewed from below. Note that an X axis, a Y axis, and a Z axis illustrated in each of all figures indicate the common directions. In addition, upward and downward in the description indicate the Z-axis direction.

For one battery cell 15 held by the rotation holding unit 30, the measurement device 10 can measure its magnetic flux density while changing its angle state and its relative position with respect to the sensor cells 22. Although an example is illustrated where the rotation holding unit 30 holds a cylindrical battery cell 15 in the present embodiment, the present embodiment is not limited thereto, and a battery cell 15 having a polyhedral shape such as a hexahedron may be a subject to be measured by the measurement device 10 of the present embodiment.

The rotation holding unit 30 includes a sensor substrate 200, column portions 210 and 215, a transversal portion 220, a slider 225, a sensor moving portion 230, a cell substrate 235, mounting portions 240 and 245, a first energizing terminal 250, a second energizing terminal 255, and a rotating portion 260. The cell substrate 235, the mounting portions 240 and 245, the first energizing terminal 250, the second energizing terminal 255, and the rotating portion 260 constitute the holding jig 60 which rotatably holds the battery cell 15 and energizes the battery cell 15.

The sensor 20 is fixed to the sensor substrate 200. The sensor 20 may be fixed to the sensor substrate 200 of the present embodiment such that the sensor 20 is arranged above the cell substrate 235 via the column portions 210 and 215, the transversal portion 220, the slider 225, and the sensor moving portion 230. The sensor 20 may be fixed to the sensor substrate 200 in a position where a magnetic flux density generated by the battery cell 15 is measurable in the measurement. The sensor substrate 200 may be a sheet-shaped member or may be formed of metal or resin, but is not limited thereto.

The sensor substrate 200 has a plurality of positioning holes 202 on its upper surface (e.g., a total of 28 positioning holes 202 in Fig. 3 of the present embodiment) for determining the relative position between the sensor 20 and the battery cell 15. The plurality of positioning holes 202 may be for positioning the cell substrate 235 in a plurality of different positions. The plurality of positioning holes 202 may be through-holes or may be recessed portions of the sensor substrate 200, which are not penetrated therethrough. The plurality of positioning holes 202 may be provided to individually correspond to positions of a plurality of battery cells 15 in the subject battery unit that is a genuine product. This enables the rotation holding unit 30 to hold the battery cell 15 such that the relative position between the battery cell 15 and the sensor 20 is changeable. The measurement device 10 can measure the magnetic field of the battery cell 15 in a plurality of different relative positions with respect to the sensor 20 by means of the plurality of positioning holes 202.

Each of the two column portions 210 and 215 has its lower end fixed around a different end of the sensor substrate 200 and extends upward. The transversal portion 220 is fixed between an upper end of one of the column portions 210 and an upper end of another of the column portions 215 and transverses over the sensor substrate 200. The slider 225 is fixed in a middle of the transversal portion 220 and has a recessed portion extending upward and downward.

The sensor moving portion 230 is installed to be movable along the recessed portion of the slider 225 and is fixed such that the sensor 20 faces the battery cell 15 to be measured (or the upper surface of the sensor substrate 200). The sensor 20 may be fixed to the sensor moving portion 230 such that the plurality of sensor cells 22 in the two-dimensional array are arranged along an upper surface of the cell substrate 235. The sensor moving portion 230 may be connected to the control unit 40 and include an actuator (an electric motor, a hydraulic cylinder, or the like, as an example), which moves up and down with respect to the slider 225 under the control by the control unit 40. As such sensor moving portion 230 moves up and down, the sensor 20 fixed to the sensor moving portion 230 is moved up and down. The sensor moving portion 230 may be moved to a lower end of the slider 225 to arrange the sensor 20 so as to face in proximity to the battery cell 15 during the measurement and may be moved to an upper end of the slider 225 other than during the measurement such as during movement of the holding jig 60. The sensor moving portion 230 may also be moved up and down with respect to the slider 225 manually by the user. Thanks to the fact that the rotation holding unit 30 includes the slider 225 and the sensor moving portion 230, the rotation holding unit 30 can move the sensor cells 22 with respect to the battery cell 15. Such up-and-down movement of the sensor 20 allows for installing the holding jig 60 in a measurement position.

The rotating portion 260 is fixed to the cell substrate 235. The cell substrate 235 may be movable relative to the sensor substrate 200. The cell substrate 235 may be detachably arranged on the sensor substrate 200. The cell substrate 235 may be a sheet-shaped member or may be formed of metal or resin. The cell substrate 235 may include a positioning pin 237 to be inserted into the plurality of positioning holes 202 in the sensor substrate 200. The cell substrate 235 may include a plurality of positioning pins 237, and positioning thereof is performed by causing the plurality of positioning pins 237 to be individually inserted into the plurality of positioning holes 202. The positioning pin 237 may be formed so as to protrude from a lower surface of the cell substrate 235.

The mounting portions 240 and 245 are arranged between the first energizing terminal 250 and the second energizing terminal 255 and protrude from an upper surface of the cell substrate 235 to contact the battery cell 15 to be held. The mounting portions 240 and 245 have the battery cell 15 mounted on the upper surfaces thereof, and hold the battery cell 15 in a predetermined height position. Each of the mounting portions 240 and 245 may have a cuboidal shape and may include an anti-slip feature at a portion in contact with the battery cell 15 on the upper surface. A plurality of mounting portions 240 and a plurality of mounting portions 245 may be arranged between the first energizing terminal 250 and the second energizing terminal 255.

The first energizing terminal 250 is connected to one electrode of the battery cell 15 (a plus electrode, as an example) and the second energizing terminal 255 is connected to another electrode of the battery cell 15 (a minus electrode, as an example). Each of the first energizing terminal 250 and the second energizing terminal 255 may include a metal part for energizing the battery cell 15 and an anti-slip feature around the metal part for contacting with and holding the battery cell 15. In the present embodiment, the first energizing terminal 250 and the second energizing terminal 255 are connected to an electrode on one end surface of the cylindrical battery cell 15 and an electrode on another end surface, and sandwich and hold the battery cell 15 on the mounting portions 240 and 245.

The rotating portion 260 rotates the battery cell 15. The rotating portion 260 may enable the battery cell 15 to be rotated while retaining the relative position of the battery cell 15 with respect to the sensor 20. For example, the rotating portion 260 may cause the battery cell 15 to be rotated about its rotational axis in the Y-axis direction in a state where the battery cell 15 is held between the first energizing terminal 250 and the second energizing terminal 255. The rotating portion 260 may rotate the battery cell 15 by rotating the first energizing terminal 250 and the second energizing terminal 255 about the rotational axis in the Y-axis direction in the holding state. The rotational axis may be an axis that passes through centers of two end surfaces of the battery cell 15 (an axis that passes through centers of two circular end surfaces of the battery cell 15 in a case of the battery cell 15 having the cylindrical shape, as an example). The rotating portion 260 may be an actuator (a stepper motor, a servo motor, a hydraulic cylinder, or the like, as an example) connected to the control unit 40, which rotates the battery cell 15 under the control by the control unit 40. The rotating portion 260 may also enable the battery cell 15 to be rotated manually by the user.

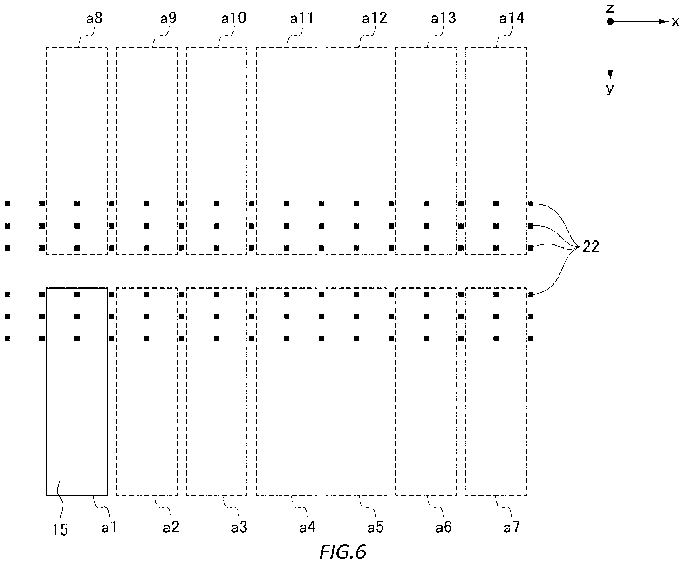

Fig. 6 illustrates an arrangement of the sensor cells 22 and the battery cell 15 during the measurement. Fig. 6 illustrates an example where data for the genuine product determination for a battery unit within which seven battery cells 15 are arranged in each of two lines is acquired
The measurement device 10 can perform the measurement while moving one battery cell 15 held by the holding jig 60 in a plurality of cell positions a1 to an (where n > 1, and in the present embodiment, n=14) with respect to the sensor cells 22 in the two-dimensional array. Each of the cell positions may be the relative position between the sensor cells 22 and the battery cell 15. The measurement device 10 performs the measurement at each angle state while rotating the battery cell 15 in each cell position ai (1 ≤ i ≤ n). In the example of Fig. 1, an example of the measurement in the relative position a1 is illustrated.

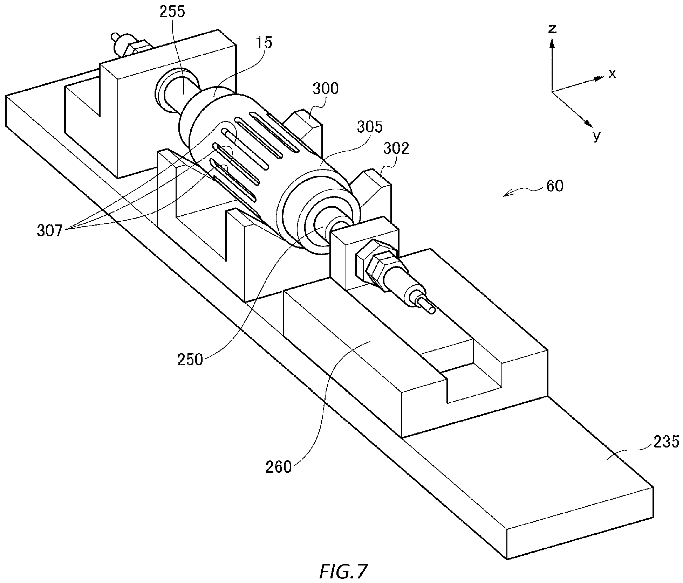

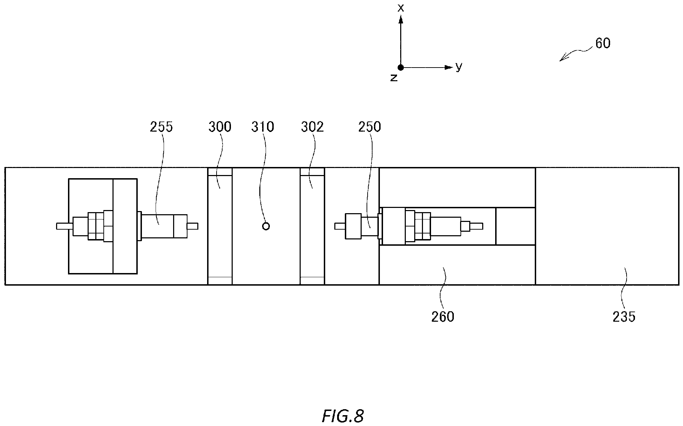

Fig. 7 illustrates a schematic perspective view of the holdingjig 60 in the rotation holding unit 30 of a first variant in the measurement device 10 of the present embodiment. Fig. 7 illustrates the holding jig 60 with the battery cell 15 in the first variant being held. Fig. 8 illustrates a schematic top plan view of the holding jig 60 with the battery cell 15 in the first variant not being held. The holding jig 60 in the first variant has a configuration and functionality similar to those of the holding jig 60 of the rotation holding unit 30 in the embodiment of Fig. 1 to Fig. 6, and, in the rotation holding unit 30, is interchangeable with the holding jig 60 in Fig. 1 to Fig. 6. For the holding jig 60 in the first variant, differences with respect to the holding jig 60 in Fig. 1 to Fig. 6 will be mainly described below.

The holding jig 60 includes the cell substrate 235, two mounting portions 300 and 302, the first energizing terminal 250, the second energizing terminal 255, the rotating portion 260, a cell holding portion 305, and a support portion 310. The cell substrate 235, the first energizing terminal 250, and the second energizing terminal 255 may have configurations and functionalities similar to those of the holding jig 60 of the measurement device 10 in the embodiment of Fig. 1 to Fig. 6.

The two mounting portions 300 and 302 are arranged between the first energizing terminal 250 and the second energizing terminal 255. The mounting portions 300 and 302 each protrude from the upper surface of the cell substrate 235 to contact with the cell holding portion 305 into which the battery cell 15 is inserted. The mounting portions 300 and 302 have the cell holding portion 305 mounted on the upper surfaces thereof, and hold the battery cell 15 in a predetermined height position. The mounting portions 300 and 302 each have a recessed portion at their upper end portions when viewed in an X-Z cross section and have the battery cell 15 mounted on the recessed portion. In Fig. 7 and Fig. 8, the mounting portions 300 and 302 each have a V-shaped recessed portion at the upper end portions when viewed in the X-Z cross section. Note that, the shape of the recessed portion is not limited thereto, and it may also be a U-shaped recessed portion along a shape of a side surface of the battery cell 15. The mounting portions 300 and 302 may each include an anti-slip feature at a portion in contact with the battery cell 15 on the upper surface of the recessed portion.

The cell holding portion 305 has the battery cell 15 inserted thereinto and includes a recessed portion for defining a rotation angle. The cell holding portion 305 may have a hollow portion into which the battery cell 15 is to be inserted. The cell holding portion 305 may have a shape that fits the shape of the battery cell 15, and, in the present embodiment, is a hollow cylindrical shape. The cell holding portion 305 may be arranged to contact with the mounting portions 300 and 302 in a state where the battery cell 15 is inserted during the measurement. The cell holding portion 305 may include a plurality of recessed portions formed for each predetermined rotation angle on its side surface (at predetermined angle intervals). The recessed portions may be formed to be penetrated through the side surface of the cell holding portion 305 and expose the side surface of the battery cell 15 to be held, or may be formed not to be penetrated through the side surface of the cell holding portion 305. The recessed portions may be formed to be elongated along the side surface of the cell holding portion 305. The recessed portions may be formed in a position that will be located between the two mounting portions 300 and 302 during the measurement. The cell holding portion 305 may be formed of metal or resin.

The support portion 310 is fixed to the cell substrate 235 and contacts with and supports the recessed portion of the cell holding portion 305. The support portion 310 may be arranged between the two mounting portions 300 and 302. The support portion 310 may have a shape such that it can be inserted into the recessed portion of the cell holding portion 305. For example, the support portion 310 may have a pin-like shape formed to protrude from the upper surface of the cell substrate 235 and, when the cell holding portion 305 into which the battery cell 15 is inserted is mounted on the mounting portions 300 and 302, may be inserted into the recessed portion of the cell holding portion 305. This allows for easily adjusting the angle of the battery cell 15 by the recessed portion of the cell holding portion 305 even when placing the cell holding portion 305 manually by the user.

The support portion 310 may be rotatable about a rotational axis that is the same as the rotational axis of the battery cell 15. The support portion 310 may be fixed to the two mounting portions 300 and 302 and be rotatable about the rotational axis that is the same as the rotational axis of the battery cell 15 together with the mounting portions 300 and 302 with respect to the cell substrate 235. The support portion 310 may be rotatable by a rotation angle less than an angle between adjacent recessed portions of the cell holding portion 305. As an example, when the recessed portions of the cell holding portion 305 are formed around the rotational axis in 10-degree intervals, the support portion 310 and the mounting portions 300 and 302 may be rotatable by ± 5 degrees about the rotational axis. This allows for adjusting the angle between the adjacent recessed portions of the cell holding portion 305. The support portion 310 may be connected to the control unit 40 and may include an actuator (an electric motor such as a brush motor, a hydraulic cylinder, or the like, as an example), which rotates the support portion 310 under the control by the control unit 40.

Note that the cell holding portion 305 may include a protruding portion, and in this case, the support portion 310 may be for contacting with and holding the protruding portion of the cell holding portion 305. For example, the cell holding portion 305 may include a plurality of pin-like protruding portions radially protruding from the side surface of the cell holding portion 305. When the cell holding portion 305 into which the battery cell 15 is inserted is mounted on the mounting portions 300 and 302, the support portion 310 may have a recessed upper end portion into which one of the protruding portions of the cell holding portion 305 is inserted. The support portion 310 may also be formed on the upper surface of the cell substrate 235 as a recessed portion into which one of the protruding portions of the cell holding portion 305 is inserted.

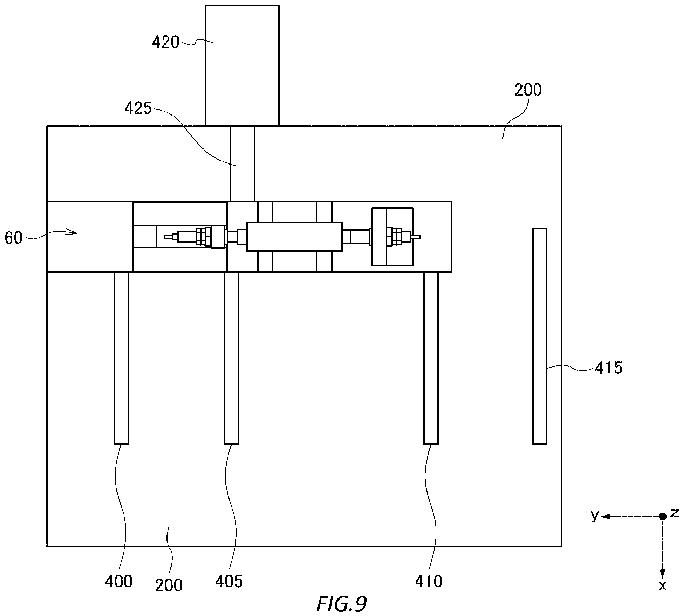

Fig. 9 illustrates a schematic top plan view of a part of the rotation holding unit 30 of a second variant in the measurement device 10 of the present embodiment. Fig. 9 illustrates some part of the rotation holding unit 30 and omits other parts thereof. The rotation holding unit 30 of a second variant has a configuration and functionality similar to those of the rotation holding unit 30 of the measurement device 10 of the embodiment in Fig. 1 to Fig. 6, except that it does not include the plurality of positioning holes 202, but includes rails 400, 405, 410, and 415 and a cell moving portion 420. Differences with respect to the rotation holding unit 30 in Fig. 1 to Fig. 6 will be mainly described below.

The sensor substrate 200 includes rails 400, 405, 410, and 415 for moving the relative position between the sensor 20 and the battery cell 15. The rails 400, 405, 410, and 415 are for moving the cell substrate 235 with respect to the sensor 20. The rails 400, 405, 410, and 415 each are recessed to extend on the upper surface of the sensor substrate 200 in the X-axis direction, and the cell substrate 235 is movable along the rails 400, 405, 410, and 415. The positioning pins 237 on the lower surface of the cell substrate 235 may be inserted into the rails 400, 405, 410, and 415, and the cell substrate 235 may be movable along the rails 400, 405, 410, and 415 in the X-axis direction. The rails 400, 405, 410, and 415 allows for positioning in the Y-axis direction by moving the cell substrate 235 between the different rails 400, 405, 410, and 415. A plurality of rails 400, 405, 410, and 415 may be arranged in parallel with each other. In the present embodiment, each of two positioning pins 237 of the cell substrate 235 are inserted into each of two rails 400 and 410, and the holding jig 60 is movable manually by the user between two different positions in the Y-axis direction, that is, between a set of two rails 400 and 410 and a set of two rails 405 and 415. This allows for moving the cell substrate 235 on the plurality of rails 400, 405, 410, and 415, and, when the subject battery unit is constituted by the battery cells 15 in multiple lines, allows for acquiring data depending on the subject battery unit. In addition, these rails may be any mechanism that allows the sensor 20 and the battery cell 15 to move relatively to each other on the sensor substrate 200, for example, may be grooves.

The cell moving portion 420 moves the relative position between the sensor 20 and the battery cell 15. The cell moving portion 420 may move the holding jig 60 holding the battery cell 15 on the rails 400, 405, 410, and 415. The cell moving portion 420 may be fixed to the sensor substrate 200 and may move the cell substrate 235 on the rails 400, 405, 410, and 415 with respect to the sensor substrate 200. The cell moving portion 420 may include a telescoping portion 425. One end of the telescoping portion 425 may be fixed to the cell substrate 235. The cell moving portion 420 may move the cell substrate 235 on the rails 400, 405, 410, and 415 by causing the telescoping portion 425 to telescope in the X-axis direction by means of an actuator (an electric motor such as a brush motor, a hydraulic cylinder, or the like, as an example). The cell moving portion 420 may be connected to the drive unit 120 of the control unit 40 and may cause the telescoping portion 425 to telescope under the control by the control unit 40. Thereby, the control unit 40 may control the relative position between the sensor 20 and the battery cell 15, and, in each of at least two relative positions, take in measurement results at at least two rotation angles. Note that the cell moving portion 420 may automatically move the holding jig 60 in the Y-axis direction under the control by the control unit 40. In this case, the cell moving portion 420 may move the holding jig 60 by ascending it in the Z-axis direction from the two rails 400 and 410, moving it in the Y-axis direction, and then descending it onto the different rails 405 and 415.

Note that a part of the configurations of the rotation holding unit 30 in the variants 1 and 2 may be interchangeable with any part of that of the rotation holding unit 30 of the measurement device 10 in Fig. 1 to Fig. 6.

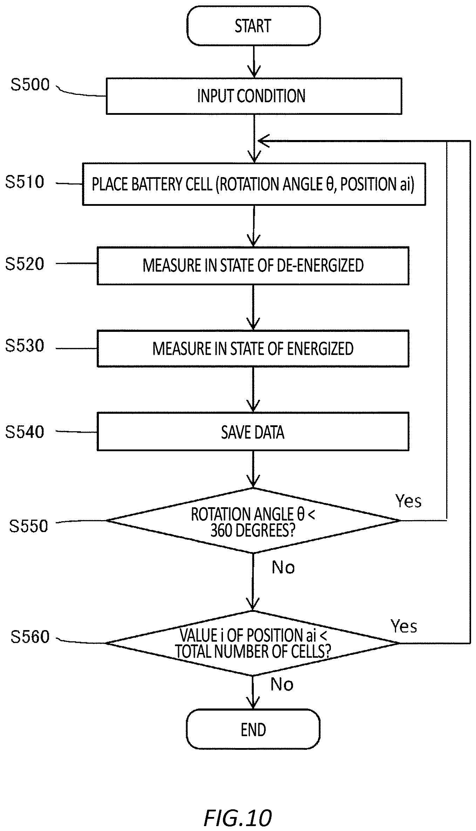

Fig. 10 is a flow diagram illustrating a measurement operation of the measurement device 10 of the present embodiment. The measurement device 10 may start the measurement operation once a power supply is turned ON. In the present embodiment, as an example, the measurement device 10 generates a measurement result database used for the genuine product determination on the battery unit including the battery cells 15 arranged as illustrated in Fig. 6.

In Step S500, a measurement condition may be input from the user via the input device 70 to the condition input unit 100. The measurement condition including at least one of a current value of a current caused to flow through the battery cell 15 during the measurement, an interval between the rotation angles of the battery cell 15, a number of times of the measurement at each cell position and each angle state, information about the cell positions (a number of cell positions, coordinates indicating cell positions with respect to the sensor 20, or the like), information indicating the battery cell 15 to be measured (a type, a shape, product identification information, or the like), or information indicating the genuine battery unit (a number, an arrangement, an angle state, a type, a shape, or product identification information of the battery cell 15 included therein, or the like) may be input to the condition input unit 100.

In Step S510, the measurement device 10 places one battery cell 15 in the cell position ai. At a first measurement (the rotation angle θ = 0 degree, the cell position a1), the user may manually place the battery cell 15. A reference marker for the rotation angle may be applied to the battery cell 15 in the position of the battery tab or the like. At the first measurement, the user may cause the first energizing terminal 250 and the second energizing terminal 255 to sandwich and hold the battery cell 15 such that the reference marker coincides with a predetermined position (a position in which it faces right above, as an example) in the holding jig 60. The drive unit 120 may control to ascend the sensor moving portion 230 on the slider 225 before the placement of the battery cell 15, and to descend the sensor moving portion 230 on the slider 225 such that the sensor 20 is placed in the measurement position after the placement of the battery cell 15.

In Step S520, the measurement device 10 measures a magnetic flux density by the sensor 20 in a state where the held battery cell 15 is not energized. The processing unit 130 may take in each magnetic flux density from each of the plurality of sensor cells 22. This enables the processing unit 130 to acquire the magnetic flux density.

In Step S530, the measurement device 10 measures the magnetic flux density in the state where the battery cell 15 is energized. The energization unit 110 may pass a current through the battery cell 15 via the first energizing terminal 250 and the second energizing terminal 255 depending on a registered current value indicated in the input measurement condition. Here, the registered current value may be a set current value of the current to be passed through the battery cell 15 within the battery unit in the genuine product determination. For example, the control unit 40 may take in a measurement result of the magnetic flux density at the sensor 20 by the processing unit 130 when passing a current having a current value higher than the registered current value through the battery cell 15 by the energization unit 110. As an example, the energization unit 110 may pass a current having a current value calculated by multiplying the registered current value by a predetermined energizing coefficient (a value depending on a number of the battery cells 15 in the subject battery unit (hereinafter, also referred to as a total number of cells), as an example) through the battery cell 15. As an example, the predetermined energizing coefficient may be V (total number of cells). Passing such a current having a high current value depending on the number of the battery cells 15 can reduce noises in the magnetic field measurement by division by the same energizing coefficient when using the measurement result of the measurement device 10 in the genuine product determination on the battery unit.

The processing unit 130 may output a difference between the magnetic flux density measured in the state of energizing and the magnetic flux density measured in Step S520 as the measurement result to the storage unit 140.

In Step S540, the storage unit 140 receives from the processing unit 130 the measurement result that indicates the magnetic flux density and records it in the measurement result database. The storage unit 140 may record in the measurement result database the measurement result in association with the registered current value. The storage unit 140 may further record in the measurement result database at least one of a current value in the measurement received from the energization unit 110, information indicating the drive of the rotation holding unit 30 received from the drive unit 120 (the rotation angle, the cell position, or the like), or information indicating the subject battery unit input to the condition input unit 100, in association with the measurement result.

In Step S550, the measurement device 10 determines whether the rotation angle θ of the current battery cell 15 is less than 360 degrees. The measurement device 10 may calculate a total rotation angle θ of the battery cell 15 in the current cell position from the information received from the drive unit 120 (information of the rotation angle and a number of rotations, as an example). When the rotation angle is less than 360 degrees (Yes in S550), the measurement device 10 proceeds to Step 510. When the rotation angle is greater than or equal to 360 degrees (No in S550), the measurement device 10 proceeds to Step 560.

In Step S510 that follows Step S550, the measurement device 10 changes the rotation angle of the battery cell 15 into a next angle state. For example, the drive unit 120 rotates the battery cell 15 by a predetermined rotation angle by the rotating portion 260. As an example, the drive unit 120 rotates the battery cell 15 by the predetermined rotation angle (e.g., 10 degrees) by the rotating portion 260 about a rotational axis that passes through a center of the first energizing terminal 250 and a center of the second energizing terminal 255. Then, Steps S520 to S550 may be repeated.

In Step S560, the measurement device 10 determines whether the value i of the cell position ai of the current battery cell 15 is less than the total number of cells in the subject battery unit. The measurement device 10 may acquire the total number of cells from the measurement condition input to the condition input unit 100. In an example where data is acquired for the genuine product determination of the battery unit within which seven battery cells 15 are arranged in each of two lines as illustrated in Fig. 6, if the current cell position ai in which the magnetic flux density is measured is the cell position a14, the measurement device 10 may determine that the value i is not less than the total number of cells, or if the current cell position ai is any of the cell positions a1 to a13, the measurement device 10 may determine that the value i is less than the total number of cells.

When the value i of the cell position ai of the current battery cell 15 is less than the total number of cells (Yes in S560), the measurement device 10 proceeds to Step 510. When the value i of the current cell position ai is greater than or equal to the total number of cells (No in S560), the measurement device 10 may end the measurement operation.

In Step S510 that follows Step S560, the measurement device 10 moves the position of the battery cell 15 to a next cell position. For example, in the case of the rotation holding unit 30 of the second variant in Fig. 9, the drive unit 120 moves the holding jig 60 on the rails 400, 405, 410, and 415 in the X-axis direction at a predetermined distance by the cell moving portion 420. Then, Steps S520 to S560 may be repeated.

Note that the measurement device 10 may perform pre-processing on the measurement result recorded in the measurement result database after ending the measurement operation, and record the pre-processed measurement result in the measurement result database. In Steps S500 to S560, the processing unit 130 of the control unit 40 may take in a plurality of measurement results of the magnetic flux density at the sensor 20 at each of at least two rotation angles, calculate an average value of the plurality of measurement results at each rotation angle by pre-processing, and record the calculated average value in the measurement result database. The user may input to the condition input unit 100 a measurement condition for performing the measurement at multiple rotations (the total number of cells × 360 degrees, as an example) in each cell position. This enables the measurement device 10 to repeat Steps S500 to S560 even after ending the measurement operation in Step S560 (No in S560). The measurement device 10 can take in a same number of magnetic flux densities as a number of rotations at each rotation angle in each cell position (a same number of magnetic flux densities as the total number of cells, as an example) by the processing unit 130 by performing the measurement while rotating the battery cell 15 multiple times in each cell position. Therefore, the processing unit 130 may calculate the average value of the plurality of magnetic flux densities taken in at each rotation angle in each cell position, and record it in the measurement result database. As an example, the processing unit 130 can take in a same number of measurement results as the total number of cells at each rotation angle in each cell position to calculate the average value.

Calculating such an average value can suppress a standard deviation of noises in the measurement results to e.g., 11V (total number of cells) times. Thus, thanks to pre-processing by repeating the magnetic field measurement of the battery cell 15 a same number of times as the total number of cells, noises superposed by adding the measurement result in each cell position during the genuine product determination can be reduced in advance by means of the pre-processing.

Note that the measurement device 10 may omit Step S540, store the measurement result in the processing unit 130, also perform the pre-processing on the stored measurement result before ending the measurement operation, and record the pre-processed measurement result in the measurement result database after ending the measurement operation.

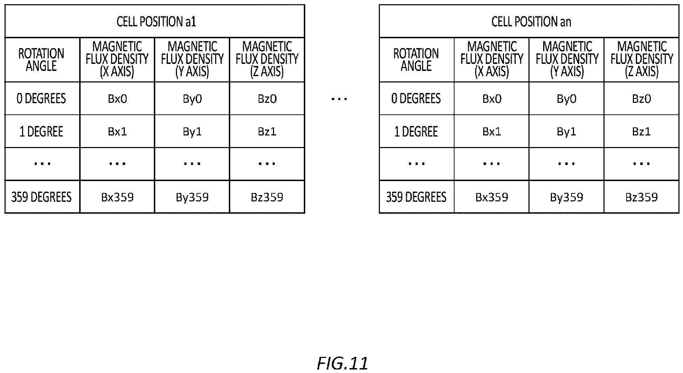

Fig. 11 illustrates an example of the measurement result database which records measurement results in the measurement device 10. The measurement result database records the measurement results in association with the cell position a1 to the cell position an. Fig. 11 omits measurement results in a cell position a2 to a cell position an-1.

The measurement result database records each rotation angle and corresponding magnetic flux densities in the X axis, the Y axis, and the Z axis in each cell position. In Fig. 11, the rotation angle is a rotation angle of the battery cell 15 from a reference position (the rotation angle is 0 degrees).

The magnetic flux densities (in the X axis) are magnetic flux densities in the X-axis direction measured from one battery cell 15 at corresponding rotation angles and are measured values taken in from the plurality of sensor cells 22. As an example, Bx0 is a magnetic flux density of the plurality of sensor cells 22 in the X-axis direction at the rotation angle 0 degrees in the cell position a1, and therefore indicates a same number of the magnetic flux densities as the number of the sensor cells 22. The magnetic flux densities (in the Y axis) are magnetic flux densities in the Y-axis direction measured from one battery cell 15 at corresponding rotation angles and are magnetic flux densities taken in from the plurality of sensor cells 22. As an example, By0 is a magnetic flux density of the plurality of sensor cells 22 in the Y-axis direction at the rotation angle 0 degrees in the cell position a1, and therefore indicates a same number of the magnetic flux densities as the number of the sensor cells 22. The magnetic flux densities (in the Z axis) are magnetic flux densities in the Z-axis direction measured from one battery cell 15 at corresponding rotation angles and are magnetic flux densities taken in from the plurality of sensor cells 22. As an example, Bz0 is a magnetic flux density of the plurality of sensor cells 22 in the Z-axis direction at the rotation angle 0 degrees in the cell position a1, and therefore indicates a same number of the magnetic flux densities as the number of the sensor cells 22. Each magnetic flux density may be recorded in the measurement result database in association with corresponding positional information of the sensor cells 22.

Note that the measurement result database as illustrated in Fig. 11 may be stored in association with information (such as identification information) of the subject battery unit in the storage unit 140.

The measurement device 10 of the present embodiment can acquire data capable of expressing individuals of numerous battery units at a small number of times of the measurement by measuring the battery cells 15 one by one. For example, in the case of predicting the magnetic flux density of the battery unit constituted by 14 battery cells 15, once the rotation angle of each battery cell 15 is rotated 360 degrees in 45-degree increments, there are 8¹⁴ magnetic flux densities in all combinations. However, by measuring the magnetic flux densities of the battery cells 15 one by one the measurement device 10 of the present embodiment to acquire 8 × 14 measurement results and superpose the measurement results, the magnetic flux densities of all combinations can be reproduced.

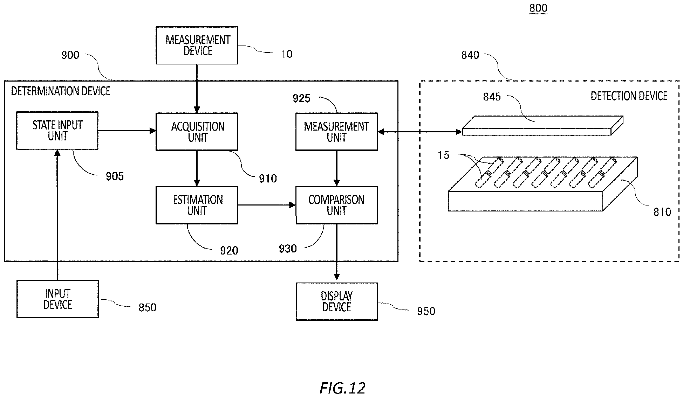

Fig. 12 illustrates a schematic view of an estimation system 800 according to the present embodiment. The estimation system 800 estimates a magnetic flux density generated by a battery unit 810 to be determined, and determines whether the battery unit 810 to be determined is a genuine product using the estimation result. The battery unit 810 may be a lithium-ion battery or the like and includes the plurality of battery cells 15 therein. The estimation system 800 includes the measurement device 10, a detection device 840, an input device 850, a determination device 900, and a display device 950. The measurement device 10 may be similar to the measurement device 10 of the present embodiment described in Fig. 1 to Fig. 11, and the description thereof is omitted.

The detection device 840 detects the magnetic flux density generated by the battery unit 810 while energizing (charging or discharging) the battery unit 810 to be determined. The detection device 840 may detect the magnetic flux density from the battery unit 810 by the sensor 845 similar to the sensor 20 of the measurement device 10 on a same condition as the measurement condition of the measurement device 10 (such as the relative position between the battery cell 15 and the sensor cell 22).

The input device 850 may be a terminal used by the user (a PC, a smartphone, or the like), a keyboard, a touch panel, a mouse, or the like. Various information for the genuine product determination is input from the user to the input device 850.

The determination device 900 determines whether the battery unit 810 to be determined is a genuine product from the magnetic flux density detected by the detection device 840. The determination device 900 includes a state input unit 905, an acquisition unit 910, an estimation unit 920, a measurement unit 925, and a comparison unit 930.

The state input unit 905 is connected to the input device 850. Information of the battery unit 810 to be determined is input via the input device 850 to the state input unit 905. For example, for the battery unit 810 including a plurality of battery cells 15, state data indicating the arrangement and the angle state of each of the battery cells 15 within the battery unit 810 is input to the state input unit 905. The state data may be information assuming that the battery unit 810 is a genuine product.

The acquisition unit 910 is connected to the state input unit 905 and the measurement device 10. The acquisition unit 910 may include an acquisition database. The acquisition unit 910 acquires a measurement result actually measured using the measurement device 10 to record it in the acquisition database. For at least one type of the battery cells 15 used for the battery unit 810, the acquisition database records the measurement result obtained by actually measuring the magnetic flux density for each angle state when passing a current while changing the angle state of the battery cells 15.

The estimation unit 920 is connected to the acquisition unit 910. The estimation unit 920, based on the angle state of each of the battery cells 15 and the measurement result recorded in the acquisition database, determines the magnetic flux density generated by each of the battery cells 15, and, based on the magnetic flux density generated by each of the battery cells 15 and the arrangement of each of the battery cells 15 in the battery unit 810, performs the estimation to yield an estimated magnetic flux density generated by the battery unit 810.

The measurement unit 925 is connected to the detection device 840. The measurement unit 925 may control the sensor 845 of the detection device 840 to measure the magnetic flux density of the battery unit 810 to be determined, and takes in the measurement result of the magnetic flux density in the sensor 845.

The comparison unit 930 is connected to the estimation unit 920 and the measurement unit 925. The comparison unit 930 compares the measurement result of the magnetic flux density taken in by the measurement unit 925 with the estimated magnetic flux density yielded by the estimation by the estimation unit 920 to perform the genuine product determination of the battery unit 810 to be determined.

The display device 950 is connected to the comparison unit 930. The display device 950 may be a PC, a display, or the like, and may display a result of the genuine product determination by the comparison unit 930.

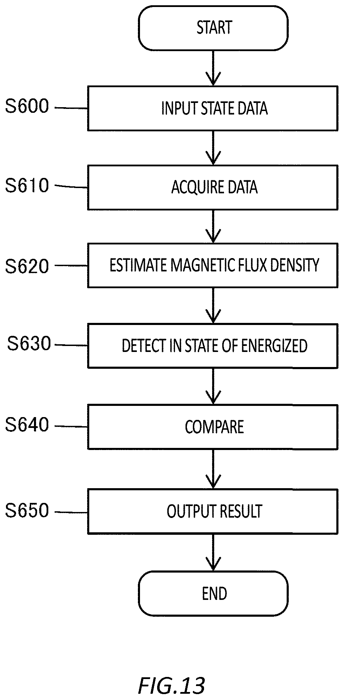

Fig. 13 illustrates a flow diagram of the genuine product determination operation in the estimation system 800 according to the present embodiment.

In Step S600, state data is input to the state input unit 905. The state data may include information indicating the battery unit 810. For example, the state data may include at least one of a number, a type, or an arrangement of the plurality of battery cells 15 within the battery unit 810, an angle state in a position of each battery cell 15 (an angle state with a position of a lead wire being set as a reference position of 0 degrees, or the like, as an example), or identification information of the battery unit 810 (a manufacturing number, a type, or the like). Here, the arrangement of the plurality of battery cells 15 may be a relative position of each battery cell 15 with respect to the sensor 845, for example, may be coordinates with respect to a center of an X-Y plane in the battery unit 810. The state data may also be input from the detection device 840 to the state input unit 905. The state input unit 905 outputs the state data to the acquisition unit 910.

In Step S610, the acquisition unit 910 acquires the measurement result to be estimated from the measurement device 10 depending on the state data input to the state input unit 905, and records the acquired measurement result in the acquisition database. The acquisition unit 910 may have information such as the angle state or the arrangement of the battery cells 15 for the battery unit 810, and, once the state data including the identification information of the battery unit 810 is input, may acquire from the measurement device 10 a measurement result depending on the information such as the angle state or the arrangement corresponding to the state data. The acquisition unit 910 may associate the cell positions, the rotation angles, and the magnetic flux densities with each other and record them in the acquisition database, similar to the measurement result database of the measurement device 10 as illustrated in Fig. 11. The acquisition unit 910 may acquire the measurement result corresponding to each angle state in all cell positions in the measurement database.

As an example, in a case of the arrangement where seven battery cells 15 are arranged in each of two lines as illustrated in Fig. 6, when the state data indicates that the rotation angle in the cell position a1 is one degree,..., and that the rotation angle in the cell position an (where, n = 14 in the case of the battery unit 810 in Fig. 6) is 50 degrees, the acquisition unit 910 may acquire from the measurement device 10 the magnetic flux densities Bx1, By1, and Bz1 in the cell position a1 in Fig. 11,..., and the magnetic flux densities Bx50, By50, and Bz50 in the cell position an. The acquisition unit 910 may acquire from the measurement device 10 the measurement results of the plurality of sensor cell 22 at each rotation angle in each cell position to record them in the acquisition database. As an example, the acquisition unit 910 may record, as the magnetic flux density Bx50, a same number of magnetic flux densities in the X-axis direction as the number of the sensor cells 22 in association with information of the arrangement of the sensor cells 22 (the identification information, coordinates, or the like) in the acquisition database.

In addition, the acquisition unit 910 may acquire a measurement condition in the measurement device 10 (a current value when energizing the battery cell 15 during the measurement, an energizing coefficient, a registered current value, or the like, as an example) to record it in association with the measurement result in the acquisition database.

In Step S620, the estimation unit 920 estimates the magnetic flux density generated by the battery unit 810 using the measurement results recorded in the acquisition database. For one combination of the arrangements and the angle states of the plurality of battery cells 15 indicated in the state data, the estimation unit 920 may estimate a sum of the acquired magnetic flux densities as the estimated magnetic flux density generated by the battery unit 810. The estimation unit 920 may estimate a sum of the magnetic flux densities in each of three axis directions as the estimated magnetic flux density. When the sensor 20 includes the plurality of sensor cells 22, the estimation unit 920 may estimate, for each of the sensor cells 22, a sum of the magnetic flux densities in all cell positions a1 to an (i.e., a value obtained by summing a same number of the magnetic flux densities as the total number of cells) as the estimated magnetic flux density. This enables the estimation unit 920 to calculate the estimated magnetic flux density in a position where the sensor cells 22 are arranged and to obtain a distribution of the estimated magnetic flux density in the X-Y plane.

As an example, in the case of the arrangement where seven battery cells 15 are arranged in each of two lines as illustrated in Fig. 6, when the state data indicates that the rotation angle of the cell position a1 is one degree,..., and that the rotation angle of the cell position an is 50 degrees, the estimation unit 920 may calculate, for the measurement result of each sensor cell 22 in the X-axis direction, a sum of the magnetic flux densities in the cell position a1 to an (Bx1 + ... + Bx50) as the estimated magnetic flux density in the X-axis direction. Similarly, the estimation unit 920 may calculate, for the measurement result of each sensor cell 22 in the Y-axis direction, a sum of the magnetic flux densities in the cell position a1 to an (By1 + ... + By50) as the estimated magnetic flux density in the Y-axis direction. Similarly, the estimation unit 920 may calculate, for the measurement result of each sensor cell 22 in the Z-axis direction, a sum of the magnetic flux densities in the cell position a1 to an (Bz1 + ... + Bz50) as the estimated magnetic flux density in the Z-axis direction.

When an energizing coefficient is associated with the measurement result acquired by the acquisition unit 910, the estimation unit 920 may remove noises during the measurement by dividing the magnetic flux density of the measurement result by the energizing coefficient. The estimation unit 920 may divide the sum of the measurement results by the energizing coefficient to calculate the estimated magnetic flux density.

The estimation unit 920 may calculate a difference between the sum of the measurement results acquired by the acquisition unit 910 (i.e., the estimated magnetic flux density obtained by estimation similar to the above) and a reference magnetic flux density as the estimated magnetic flux density. The estimation unit 920 may acquire measurement results with the same arrangement and different angle states of the battery cells 15 as/than those in the measurement results to be estimated indicated in the state data (e.g., measurement results obtained by the same measurement device 10 as that performed the measurement and yielded the measurement results to be estimated and with the angle state being 0 degrees in all cell positions) via the acquisition unit 910. For the acquired measurement results, the estimation unit 920 may calculate to yield the sum of them similar to the measurement results to be estimated and regard the sum as the reference magnetic flux density. For the measurement result on each sensor cell 22, the estimation unit 920 may calculate the distribution of the estimated magnetic flux density in the positions of the plurality of sensor cell 22 by calculating the difference between the sum of the measurement results to be estimated and the reference magnetic flux density. This allows for removing from the estimated magnetic flux density noises caused by the magnetic field from the configuration of the measurement device 10.

The estimation unit 920 may also calculate the distribution of the estimated magnetic flux density that is weighted depending on a current proportion of currents flowing through the respective battery cells 15 in the battery unit 810. The estimation unit 920 may perform weighting by multiplying the magnetic flux density by a different weight for each cell position and regard a sum of the weighted magnetic flux densities as the estimated magnetic flux density. The current proportion of the currents flowing through the respective battery cells 15 in the battery unit 810 may be determined in advance by means of an experiment or a simulation on a genuine product corresponding to the battery unit 810. The estimation unit 920 may multiply the magnetic flux density measured in a cell position having a higher current proportion by a higher weight and multiply the magnetic flux density measured in a cell position having a lower current proportion by a lower weight. This enables the estimation unit 920 to perform the estimation to yield the estimated magnetic flux density that reflects the bias in currents through the plurality of battery cells 15 in the battery unit 810 during energizing.

In Step S630, the measurement unit 925 takes in the magnetic flux density detected by the detection device 840 with the battery unit 810 to be determined being energized. As an example, the detection device 840 may be arranged in a charging station where a car equipped with the battery unit 810 to be determined or the like is charged, and come into proximity of the battery unit 810 to be determined upon charging to detect the magnetic flux density. Upon detecting, the battery unit 810 to be determined and the sensor 845 may be arranged in the detection device 840 in a positional relationship that is the same as the relative position between the sensor 20 (sensor cells 22) and the battery unit (battery cells 15) in the measurement device 10 as illustrated in Fig. 2 and Fig. 6. The detection device 840 may detect the magnetic flux density in response to the start of charging of the battery unit 810 to be determined and output the measurement result to the measurement unit 925. The detection device 840 may output to the comparison unit 930 the distribution of the magnetic flux density in the X axis, the distribution of the magnetic flux density in the Y axis, and the distribution of the magnetic flux density in the Z axis respectively obtained by detecting the magnetic flux densities in the X-axis, Y-axis, and Z-axis directions by the plurality of sensor cells of the sensor 845.

In Step S640, the comparison unit 930 compares the magnetic flux density detected by the detection device 840 with the estimated magnetic flux density obtained by estimation by the estimation unit 920. The comparison unit 930 may compare between the detected magnetic flux density and the estimated magnetic flux density in corresponding positions of the measurement device 10 and the detection device 840 (the sensor cell in the same position),. If the difference between the detected magnetic flux density and the estimated magnetic flux density is within a predetermined range, the comparison unit 930 may determine that the battery unit 810 to be determined is a genuine product. If the difference between the detected magnetic flux density and the estimated magnetic flux density is outside the predetermined range, the comparison unit 930 may determine that the battery unit 810 to be determined is not a genuine product.

In Step S650, the comparison unit 930 outputs a comparison result. The comparison unit 930 may output display data for displaying the comparison result on the display device 950.

The present embodiment allows for efficiently estimating the magnetic flux density of the genuine product with less data by superposing the magnetic flux densities actually measured in the respective cell positions in advance. This allows for efficiently determining the battery unit including a battery cell that is not a genuine product.

Note that the estimation system 800 can also perform the genuine product determination by the genuine product determination operation of the present embodiment on the battery unit 810 for which the angle state of the battery cell 15 is not specified. In this case, the determination device 900 may perform estimation to yield a plurality of estimated magnetic flux densities for a plurality of combinations of angle states of the battery cell 15 to compare each of the plurality of estimated magnetic flux densities with the magnetic flux density detected by the detection device 840. The present example will be described below.

Firstly in Step S600, for one arrangement of a plurality of battery cells 15 in the Z-Y plane of the battery units 810, a plurality of combinations of angle states of the battery cells 15 (e.g., a plurality of different combinations with an angle interval being predetermined) may be input to the state input unit 905 as state data. As an example, for the arrangement of cell positions as illustrated in Fig. 6, state data may be input to the state input unit 905, wherein the state data indicates a combination in which the rotation angle of the cell position a1 is zero degrees, the rotation angle of the cell position a2 is 10 degrees,..., and the rotation angle of the cell position an is 10 degrees; a combination in which the rotation angle of the cell position a1 is 10 degrees, the rotation angle of the cell position a2 is 10 degrees,..., and the rotation angle of the cell position an is 10 degrees; and a combination in which the rotation angle of the cell position a1 is 20 degrees, the rotation angle of the cell position a2 is 10 degrees,..., and the rotation angle of the cell position an is 10 degrees.

Then in Step S610, the acquisition unit 910 may individually acquire measurement results of the plurality of combinations of the angle states depending on the state data. In Step S620, the estimation unit 920 may individually estimate the plurality of estimated magnetic flux densities from the measurement results of the acquired plurality of combinations. In Step S640, the comparison unit 930 compares the magnetic flux density detected by the detection device 840 with each of the plurality of estimated magnetic flux densities obtained by estimating by the estimation unit 920. If a difference between at least one of the plurality of estimated magnetic flux densities and the detected magnetic flux density is within a predetermined range, the comparison unit 930 can determine that the battery unit 810 to be determined is a genuine product. On the contrary, if the difference between any of all the plurality of estimated magnetic flux densities and the detected magnetic flux density is outside the predetermined range, the comparison unit 930 can determine that the battery unit 810 to be determined is not a genuine product.

Note that, the state input unit 905, the acquisition unit 910, and the estimation unit 920 may be included in the measurement device 10 and the estimated magnetic flux density obtained by estimating by the estimation unit 920 may be recorded in the measurement database in the storage unit 140 of the measurement device 10.

While the present invention has been described with the embodiments, the technical scope of the present invention is not limited to the above-described embodiments. It is apparent to persons skilled in the art that various alterations or improvements can be added to the above-described embodiments. It is also apparent from the description of the claims that the form to which such alterations or improvements are made can be included in the technical scope of the present invention.

It should be noted that each process of the operations, procedures, steps, stages, and the like performed by an apparatus, system, program, and method shown in the claims, the specification, or the drawings can be realized in any order as long as the order is not indicated by "prior to," "before," or the like and as long as the output from a previous process is not used in a later process. Even if the operation flow is described by using phrases such as "first" or "next" for the sake of convenience in the claims, specification, and drawings, it does not necessarily mean that the process must be performed in this order.

### EXPLANATION OF REFERENCES

10: measurement device;
15: battery cell;
20: sensor;
22: sensor cell;
30: rotation holding unit;
40: control unit;
60: holding jig;
70: input device;
100: condition input unit;
110: energization unit;
120: drive unit;
130: processing unit;
140: storage unit;
200: sensor substrate;
202: positioning hole
210: column portion;
215: column portion;
220: transversal portion;
225: slider;
230: sensor moving portion;
235: cell substrate;
240: mounting portion;
245: mounting portion;
250: first energizing terminal;
255: second energizing terminal;
260: rotating portion;
300: mounting portion;
302: mounting portion;
305: cell holding portion;
310: support portion;
400: rail;
405: rail;
410: rail;
415: rail
420: cell moving portion;
800: estimation system;
810: battery unit;
840: detection device;
845: sensor;
850: input device;
900: determination device;
905: state input unit;
910: acquisition unit;
920: estimation unit;
925: measurement unit;
930: comparison unit;
950: display device.

## Claims

1. A measurement device which measures a magnetic flux density emitted from a battery cell, comprising:
a sensor including sensor cells which measure the magnetic flux density; and
a rotation holding unit which rotatably holds the battery cell in a state where a relative position of the battery cell with respect to the sensor cells is retained.

2. The measurement device according to claim 1, wherein the rotation holding unit holds the battery cell such that the relative position between the battery cell and the sensor is changeable.

3. The measurement device according to claim 1 or 2, wherein the rotation holding unit includes a rotating portion which rotates the battery cell.

4. The measurement device according to claim 3, wherein the rotation holding unit moves the sensor cells with respect to the battery cell.

5. The measurement device according to claim 3 or 4, further comprising a control unit which takes in measurement results of the magnetic flux density at the sensor at at least two rotation angles of the battery cell.

6. The measurement device according to claim 5, wherein the control unit controls the relative position between the sensor and the battery cell and, in each of at least two relative positions, each relative position being identical to the relative position, takes in the measurement results at the at least two rotation angles.

7. The measurement device according to any one of claims 3 to 6, wherein the rotation holding unit further includes:
a cell substrate to which the rotating portion is fixed; and
a sensor substrate to which the sensor is fixed, wherein
the cell substrate is movable relative to the sensor substrate.

8. The measurement device according to claim 7, wherein
the sensor substrate includes a plurality of positioning holes for determining the relative position between the sensor and the battery cell, and
the cell substrate includes a positioning pin to be inserted into the plurality of positioning holes.

9. The measurement device according to claim 7, wherein the sensor substrate includes a rail for moving the relative position between the sensor and the battery cell.

10. The measurement device according to any one of claims 1 to 9, wherein the rotation holding unit includes a moving portion which moves the relative position between the sensor and the battery cell.

11. The measurement device according to claim 7, wherein the rotation holding unit includes:
a cell holding portion which has the battery cell inserted thereinto and includes a recessed portion or a protruding portion for defining a rotation angle; and
a support portion which is fixed to the cell substrate and contacts with and supports the recessed portion or the protruding portion of the cell holding portion.

12. The measurement device according to claim 11, wherein the support portion is rotatable about a rotational axis that is the same as a rotational axis of the battery cell.

13. The measurement device according to claim 5 or 6, wherein the control unit takes in a plurality of measurement results of the magnetic flux density at the sensor at each of the at least two rotation angles and records an average value of the plurality of measurement results at each rotation angle in a database.

14. The measurement device according to any one of claims 5, 6, and 13, wherein the control unit takes in a measurement result of the magnetic flux density at the sensor when passing a current having a current value higher than a registered current value through the battery cell and records in a database the measurement result of the magnetic flux density in association with the registered current value.

15. An estimation system comprising:
a database which, for at least one type of a battery cell used for a battery unit, records a measurement result obtained by actually measuring a magnetic flux density for each angle state when passing a current while changing the angle state of the battery cell;
a state input unit to which, for the battery unit including a plurality of battery cells, each battery cell being identical to the battery cell, state data indicating an arrangement and an angle state of each of the battery cells within the battery unit is input; and
an estimation unit which, based on the angle state and the measurement result recorded in the database, determines a magnetic flux density generated by each of the battery cells, and, based on the magnetic flux density generated by each of the battery cells and the arrangement of each of the battery cells, estimates a magnetic flux density generated by the battery unit.

16. The estimation system according to claim 15, further comprising an acquisition unit which acquires the measurement result actually measured using a measurement device to record it in the database, wherein the measurement device measures a magnetic flux density emitted from a battery cell and comprises:
a sensor including sensor cells which measure the magnetic flux density; and
a rotation holding unit which rotatably holds the battery cell in a state where a relative position of the battery cell with respect to the sensor cells is retained.
